Europäisches Patentamt

European Patent Office

Office européen des brevets

(11) Veröffentlichungsnummer : **0 084 330**
**B1**

# EUROPÄISCHE PATENTSCHRIFT

(45) Veröffentlichungstag der Patentschrift :
11.11.87

(51) Int. Cl.⁴ : **B 32 B 27/00**

(21) Anmeldenummer : 83100085.6

(22) Anmeldetag : 07.01.83

(54) **Mehrschichten-Flächengebilde.**

(30) Priorität : 20.01.82 DE 3201482

(43) Veröffentlichungstag der Anmeldung :
27.07.83 Patentblatt 83/30

(45) Bekanntmachung des Hinweises auf die Patenterteilung : 11.11.87 Patentblatt 87/46

(84) Benannte Vertragsstaaten :
CH DE FR GB IT LI NL

(56) Entgegenhaltungen :
EP-A- 0 065 691
US-A- 3 726 769
US-A- 4 394 402
CHEMICAL ABSTRACTS, Band 98, 4. April 1983, Seite 57, Nr. 108583e, Columbus, Ohio, US
JAPANESE PATENTS REPORT, Woche R45, 18.12.1970, Sektion A+E, Seite 1, Zusammenfassung Nr. 83739R, Derwent Publications, London, GB
H.v.BOENIG: "Plasma Science and Technology", Carl Hanser Verlag München, Wien,1982, Seiten 98-104

(73) Patentinhaber : BAYER AG
Konzernverwaltung RP Patentabteilung
D-5090 Leverkusen 1 Bayerwerk (DE)

(72) Erfinder : Hocker, Jürgen, Dr.
Eichenweg 6
D-5060 Bergisch Gladbach 2 (DE)
Erfinder : Broich, Bruno, Dr.
Althaustrasse 16
CH-8957 Spreitenbach (CH)
Erfinder : Büchel, Karl Heinz, Prof. Dr.
Dabringhausener Strasse 42
D-5093 Burscheid (DE)

# 0 084 330

## Beschreibung

Die Erfindung betrifft Laminate oder flächenhafte Verbundelemente, die eine oder mehrere Schichten aus gegebenenfalls dotiertem Polyacetylen enthalten, sowie Verfahren zu ihrer Herstellung. Der Verbund wirkt mechanisch, chemisch und elektronisch stabilisierend auf die Polyacetylen-Schicht und gestattet somit erstmals einen problemlosen Einsatz des Polyacetylens für die verschiedensten Anwendungszwecke. Das Design der Laminatstrukturen richtet sich nach den jeweiligen Anwendungszwecken und kann z. B. so angepaßt werden, daß sie mechanisch besonders beanspruchbar sind, den Polyacetylen-Film vor dem schädlichen Einfluß des Luftsauerstoffes schützen, und insgesamt ein Eigenschaftsbild aufweisen, über den ein Polyacetylen-Film allein nicht verfügt.

Es ist allgemein bekannt, daß Polyacetylen ein leitfähiges Polymer ist, das sich elektronisch wie ein Halbleiter oder gar ein Metall verhält. Im nativen Zustand beträgt die elektrische Leitfähigkeit je nach Anteil der cis- bzw. trans-Isomeren $10^{-9}$ bis $10^{-5}$ S/cm. Ähnlich den anorganischen Halbleitern kann man die elektrische Leitfähigkeit des Polyacetylens durch chemisches Dotieren mit Elektronenakzeptoren bzw. -donatoren über viele Größenordnungen bis in den metallischen Bereich erhöhen [vgl. J. of chem. Phys. 73, 946 (1980)].

Polyacetylen läßt sich nach bekannten oder beschriebenen Verfahren in Form von Folien herstellen oder ausgehend von bestimmten Modifikationen (z. B. kletten- bzw. faserförmige Polyacetylen-Teilchen) zu Folien weiterverarbeiten.

Diese Folien wären wegen ihrer außergewöhnlichen elektrischen Eigenschaften im Prinzip für eine Vielzahl technischer Anwendungen geeignet. Einer breiten Anwendung steht jedoch die hohe Oxidationsempfindlichkeit von Polyacetylen-Folien im Wege. Unter dem Einfluß von beispielsweise Luftsauerstoff verlieren sie schon nach kurzer Zeit ihre hohe elektrische Leitfähigkeit und verspröden.

In US-Patent 4 394 402 wird eine Methode angegeben, mit deren Hilfe man einen Plasmapolymerfilm auf der festen Oberfläche eines Acetylenpolymeren erzeugen kann. Das Plasmapolymer wird erzeugt aus einem gesättigten Kohlenwasserstoff mit bevorzugt 1-4 Kohlenstoffatomen bei äußerst niedrigem Druck durch verschiedene Arten elektrischer Entladung. Das Plasmapolymer ist keine Folie. Die durch Plasmapolymerisation erzeugten Überzüge sind nur Bruchteile eines Mikrometers dick. Erfindungsgemäß muß der Kunststoff in Form einer Folie vorliegen.

Die US-Patentschrift zeigt, daß der Fachmann Mehrschichtenflächengebilde auf Basis von Polyacetylenen bisher nicht durch Kaschierung von Folien unter Druck und/oder Wärmeeinwirkung hergestellt hat.

Die ältere europäische Patentanmeldung 00 65 691 beschreibt die Herstellung von Polyacetylenfolien auf Substraten, z. B. Kunststoffen. In der Regel werden die so erhaltenen Polyacetylenfolien von der Grundlage abgelöst, sind also damit nicht fest verbunden. In einigen Fällen haften sie fest an der Unterlage. Eine Lehre, solche Verbunde durch Kaschieren herzustellen, findet sich in dieser Schrift nicht.

Es wurde gefunden, daß die Flexibilität und die elektrische Leitfähigkeit einer Polyacetylen-Folie praktisch unbegrenzt erhalten bleibt, wenn man diese beidseitig mit einer sauerstoffundurchlässigen Folie beschichtet und an den Rändern versiegelt. Für die beidseitige Beschichtung einer Polyacetylen-Folie mit gasundurchlässigen Deckfolien bieten sich je nach Folienmaterial verschiedene Verfahren an. Man kann z. B. die drei Folien zwischen zwei Walzen laufen lassen und unter Druck miteinander verpressen, oder man klebt die Deckfolien direkt auf die Polyacetylen-Folie, wobei in beiden Fällen die überstehenden Ränder entweder miteinander versiegelt oder verklebt werden können. Die Herstellung des Verbundelementes erfolgt am günstigsten unter Schutzgasatmosphäre. Die gasundurchlässigen Deckfolien sind ein zusätzlicher Schutz für die mechanisch wenig beanspruchbare Polyacetylen-Folie. Das Verbundelement mit der leitfähigen Polyacetylen-Schicht läßt sich einfach und problemlos handhaben. Das Verpressen der drei Folien miteinander bewirkt in der Regel eine Dickenabnahme der Polyacetylen-Folie, u. U. bis auf ein Drittel der ursprünglichen Dicke. Hierdurch wird nicht nur das Verbundelement insgesamt dünner, sondern die spezifische Leitfähigkeit der Polyacetylen-Folie erhöht sich. Dies ist für viele Anwendungszwecke, wie beispielsweise die Verwendung eines derartigen Laminates als großflächiges Heizelement sehr erwünscht. Als zusätzliche nützliche Eigenschaft wird die elektrisch leitfähige Polyacetylen-Folie durch die Einkapselung in Deckfolien elektrisch isoliert, so daß sie beispielsweise gefahrlos als Flächenheizelement verwendet werden kann. Zur Erzielung besonders guter Eigenschaften hinsichtlich der Gas- oder Wasserdampfdurchlässigkeit, der mechanischen Festigkeit oder der elektrischen Isolation können die Deckfolien ihrerseits Verbundfolien darstellen.

Für eine Laminierung mit Polyacetylen kommen grundsätzlich alle Folienmaterialien in Frage. Besonders geeignet sind Folien aus Polyolefinen wie Polyethylen, Polypropylen, halogenierte Polyethylene wie Polyvinylchlorid, Polyvinylidenchlorid, Polyvinylidenfluorid, Polytetrafluorethylen ; Polyvinylacetat, Polyvinylalkohol, Polyacetale, Polystyrol, Polyester, Polycarbonat, Polysulfone, Polyurethane, Polyamide und Cellulosederivate wie Cellulosehydrat oder Celluloseacetat. Die Polymeren können gegebenenfalls auch als Copolymerisate vorliegen.

Geometrische Form und Ausmaße der Verbundelemente mit Polyacetylen unterliegen im Sinne der Erfindung keiner Einschränkung. Es sind sowohl kleinflächige Strukturen als auch großflächige Strukturen möglich. Besonders bevorzugt sind großflächige, folienhafte Gebilde, insbesondere Bänder beliebiger Länge und Breite.

2

Gegenstand der Erfindung sind flexible Mehrschichten-Flächengebilde aus mindestens zwei Schichten, von denen mindestens eine aus gegebenenfalls dotiertem Polyacetylen und mindestens eine weitere damit verbundene aus einer Kunststoff-Folie besteht. Insbesondere sind Gegenstand der Erfindung solche Flächengebilde, in denen die Folie aus Kunststoff sauerstoffundurchlässig ist. In einer besonderen Ausführungsform ist eine Polyacetylenschicht auf ihrer Oberseite und auf ihrer Unterseite mit einer sauerstoffundurchlässigen Folie aus Kunststoff verbunden, wobei die Ränder des so gebildeten Laminats gegen Sauerstoffeinwirkung abgedichtet sind. In einer weiteren Ausführungsform ist die Folie aus Kunststoff auf beiden Seiten mit einer Polyacetylenschicht versehen.

Für viele Anwendungszwecke ist es erforderlich, daß im Laminat oder Verbundelement die Polyacetylen-Schicht die Deckschicht bildet und somit frei zugänglich bleibt.

Laminate oder flächenhafte Verbundelemente im Sinne der Erfindung bestehen im einfachsten Fall aus einer Polyacetylen-Komponente und einer zweiten Komponente aus einer Kunststoff-Folie.

Wegen der schon erwähnten Sauerstoffempfindlichkeit der Polyacetylen-Schicht sind besonders diejenigen Laminate oder Verbundelemente bevorzugt, in denen mindestens eine Komponente eine sauerstoffundurchlässige Schicht darstellt.

Der Vorteil der Polyacetylen-Laminate gegenüber Polyacetylen-Folien besteht in ihrer höheren mechanischen Festigkeit bzw. Beanspruchbarkeit und in ihrer Schutzwirkung gegen oxidative Gase.

Die erfindungsgemäßen Laminate oder Verbundelemente lassen sich nach den verschiedensten Verfahren herstellen :

Im einfachsten Fall kaschiert man ein nach einem beliebigen Verfahren hergestelltes flächenhaftes, undotiertes oder dotiertes Polyacetylengebilde unter Druck, gegebenenfalls erhöhter Temperatur und gegebenenfalls unter Verwendung eines Klebemittels mit einer organischen Kunststoff-Folie. Nach diesem Verfahren können auch mehrere Folienschichten ein- oder beidseitig auf das Polyacetylen aufgebracht werden. Außerdem ist es möglich, nach diesem Verfahren ein beliebiges Folienmaterial beidseitig mit gegebenenfalls dotiertem Polyacetylen zu kaschieren und diese Verbundfolie mit weiteren, gegebenenfalls sauerstoffundurchlässigen Folienmaterialien zu beschichten.

Auch eine Vakuumverpackung von Polyacetylen-Folien ist möglich und führt in vielen Fällen zu einem innigen Kontakt zwischen den Folien.

Alle Verfahren zur Herstellung der Laminate bzw. flächenhaften Verbundelemente werden bevorzugt unter Schutzgasatmosphäre wie $N_2$ oder Ar durchgeführt.

Gegenstand der Erfindung sind demnach auch Laminate oder Verbundelemente, in denen die der Polyacetylen-Schicht benachbarte Schicht eine Folie aus einem Polymer bzw. auch einem leitfähigen Polymer sein kann, wobei die Polyacetylen-Schicht einen innigen elektronischen Kontakt mit der benachbarten leitfähigen Grenzfläche bildet.

Es bedeutet im Sinne der Erfindung keinerlei Einschränkung, auf welche Art und Weise die Polyacetylen-Komponente im Verbundelement oder im Laminat entsteht. Es lassen sich prinzipiell drei verschiedene Wege unterscheiden :

1. Ausgangspunkt zur Herstellung des Laminates ist eine flächige Polyacetylen-Folie, die mit anderen Kunststoff-Folien verbunden wird.

2. Die Oberfläche eines ein- oder mehrkomponentigen Substrats wird direkt mit Polyacetylen beschichtet.

Bevorzugt für die Laminatherstellung ist das zuletzt beschriebene Verfahrensprinzip, nach dem die Polyacetylen-Schicht direkt auf eine flächige Substrat-Folie aufgetragen wird. Für die Beschichtung einer Substrat-Folie mit Polyacetylen besonders geeignet ist eine stabile Suspension aus kletten- bzw. faserförmigen, gegebenenfalls dotierten Polyacetylen-Teilchen mit einem Durchmesser von 0,01 bis 1 mm und mit einer Vielzahl faserförmiger Fortsätze (« Kletten »), die man erhält, wenn man Acetylen in ein organisches Suspendiermittel unter ständigem Durchmischen in Gegenwart eines metallorganischen Mischkatalysators in eine Menge entsprechend 10 bis 100 mmol Aluminium und 5 bis 50 mmol Titantetrabutylat bzw. 1 bis 10 mmol Bis-(2,2-dimethylpropoxy)-vanadiumoxichlorid pro 1 Suspendiermittel einleitet, bis sich pro 1 Suspendiermittel ca. 3 g Polyacetylen gebildet hat.

Die beschriebene Suspension kann, gegebenenfalls nach Entfernen des Katalysators und/oder Austauch des Lösungsmittels, auf verschiedene Weise weiterverarbeitet und verwendet werden. Sie läßt sich sehr gut auf jede beliebige Substratoberfläche aufsprühen, wobei nach Verdampfen des Lösungsmittels eine homogene, festhaftende, gegebenenfalls dotierte Polyacetylen-Schicht auf der Substrat-Folie zurückbleibt.

Entscheidendes Kriterium ist der gute Verbund zwischen der Polyacetylen-Schicht und dem Substrat. Wegen der Sauerstoffempfindlichkeit des Polyacetylens erfolgt das Auftragen das Polyacetylens auf die Substratoberfläche vorzugsweise unter Schutzgasatmosphäre. Zum Versprühen geeignet sind beispielsweise Spritzpistolen mit Gasdruckantrieb. Spritzpistolen mit elektrischem Antrieb (« airless ») eignen sich besonders gut für eine kontrollierte flächige Beschichtung, da die Dicke der Polyacetylen-Schicht genau steuerbar ist und sich ab etwa 0,1 µm nach oben variieren läßt.

Als besonders vorteilhaft für die Laminatherstellung hat sich ein Vakuumsprühverfahren erwiesen. Hierbei befindet sich das zu beschichtende Substrat in einer Unterdruckkammer, in die man die Polyacetylen-Suspension über eine von außen an die Kammerwand angeflanschte, modifizierte Sprühpistole hineinsprüht. Dieses Verfahren garantiert eine besonders homogene Polyacetylen-Beschichtung, wenn man dafür sorgt, daß das von der Substratoberfläche abdampfende Lösungsmittel, welches wieder abgepumpt wird, im Gleichgewicht steht mit der neu zugeführten Menge an Lösungsmittel. Die Wachstumsgeschwindigkeit der Polyacetylen-Schicht läßt sich durch Regulierung der versprühten Menge an Polyacetylen-Suspension besonders gut steuern. Das Laminat oder das Substrat wird mit geeigneter Geschwindigkeit langsam am Sprühfeld vorbeigeführt. Diese Verfahren, die auch kontinuierlich geführt werden können, garantieren eine homogene Massenbelegung des Substrats mit Polyacetylen. Darüberhinaus garantiert die Unterdruckkammer eine feuchte- und sauerstofffreie Umgebung.

Außer durch Sprühen oder Spritzen kann das Aufbringen der Polyacetylen-Suspension auch durch Gießen, Walzen, Rakeln oder Streichen erfolgen. Foliengießmaschinen und -anlagen sind zur kontinuierlichen Herstellung von Polyacetylen-Laminaten geeignet. Hierbei wird auf einer auf Rollen laufenden Substratfolie an einer Stelle die Suspension ständig aufgebracht. Die Substratfolie führt die Polyacetylen-Masse unter Glattstreichen oder Walzen durch einen Wärmeofen mit Lösungsmitteldampfabsaugung hindurch.

Die beschriebenen Beschichtungstechniken erlauben eine homogene Verteilung der Polyacetylen-Masse auf der Substratoberfläche. Die Dosierung bzw. Einstellung der Schichtdicke ist durch die Regulierung der Auftragsmenge gut möglich.

Die erfindungsgemäßen Laminate können als elektrisch leitende oder halbleitende Bauelemente, z. B. in Flächenheizleitern, in elektronischen Devices, als Batterieelemente, für Kondensatoren oder für photovoltaische Wandler angewendet werden.

Auch als selektive Absorberflächen in photothermischen Wandlern sind Polyacetylen-Laminate geeignet.

Eine übliche mit Druckgas oder elektrisch betriebene Lackspritzpistole wird mit einer Suspension aus PAC-Teilchen gefüllt und diese auf verschiedene Substrate aufgesprüht. Beim Verdampfen des Lösungsmittels bleibt auf der Oberfläche ein homogener PAC-Rilm gut haften. Wegen der Oxidationsempfindlichkeit des PAC's werden inerte Druckgase wie z. B. Stickstoff oder Edelgase verwendet. Besonders homogene, gut haftende Filme erhält man durch Anwendung einer Unterdruckkammer. Diese gewährleistet nicht nur eine sauerstofffreie Umgebung, sondern ermöglicht gleichzeitig ein kontrolliertes Absaugen des von der Oberfläche verdampfenden Lösungsmittels. Bevorzugt wird ein dynamisches Gleichgewicht hergestellt zwischen aufgesprühter und wieder abgesaugter Lösungsmittelmenge. Die für das Verfahren verwendete Unterdruckkammer besteht aus Edelstahl mit Sichtfenstern und Absaugflansche und in die Kammer integrierter, von außen bedienbarer Sprühpistole.

Die zu beschichtende Substratfolie wird in die Kammer im geeigneten Abstand am Sprühkopf vorbeigeführt. Die Massenbelegung mit PAC wird gleichzeitig mit geeigneten Meßmethoden (z. B. Schwingquarz) kontrolliert.

Es wurden Laminate mit PAC-Schichten verschiedener Dicke hergestellt. Die PAC-Schichten paßten sich flexibel den Eigenschaften der jeweiligen Substratfolie an. In den Laminaten oder Verbundelementen wurde die PAC-Schicht mit verschiedenen Substratschichten kombiniert.

## Ausführungsbeispiele

### Beispiel 1

#### Herstellung einer Sprüh-Suspension

In eine 2-l-Becherglasrührapparatur werden 1,3 l Toluol vorgelegt und unter einem Stickstoffstrom 300 ml Toluol abdestilliert. Unter Trockeneiskühlung werden bei — 78 °C 4 ml (2 mMol) Bis-(2,2-dimethylpropoxy)-vanadiumoxichlorid 0,5 molar in Toluol und 20 ml (20 mMol) Aluminiumtriisobutyl 1 molar in Toluol zugesetzt. Die Apparatur steht dabei ständig unter einem Stickstoffstrom. Mit einer Geschwindigkeit von 10 l pro Stunde wird unter Rühren 1 Stunde reines Acetylen durchgeleitet. Das Polyacetylen fällt als Niederschlag aus. Es handelt sich um rosa bis violette, klettenförmige Gebilde mit einem Durchmesser von ca. 0,05 bis 0,5 mm. Die so erhaltene Suspension enthält 4 g Polyacetylen pro Liter. Die Reaktion wird mit 0,5 g 4-Methyl-2,6-di-tert.-butylphenol (Ionol) in 400 ml absolutem Toluol abgestoppt und das Reaktionsgemisch mit Stickstoff ausgeblasen, wobei die Temperatur auf Raumtemperatur ansteigt.

Zur Entfernung des Katalysators wird das Lösungsmittel durch Filtration teilweise entfernt, während kontinuierlich neues Lösungsmittel zugefügt wird. Auf diese Weise läßt sich auch Toluol durch ein beliebiges anderes Lösungsmittel ersetzen.

### Beispiel 2

#### Herstellung einer Sprüh-Suspension

In eine 2-l-Becherglasrührapparatur werden 1 000 ml absolutes Methylenchlorid vorgelegt. Man

kühlt auf —78 °C ab, setzt 4,2 ml (12,5 mMol) Titantetrabutylat (100 %ig) und 50 ml (50 mMol) Aluminiumtriisobutyl 1 molar in Methylenchlorid zu.

Unter Rühren werden innerhalb einer Stunde 10 g Acetylen bei — 78 °C durch die Katalysatorlösung geleitet, wobei dunkles Polyacetylen ausfällt. Die Reaktion wird mit einer Lösung aus 0,5 g 4-Methyl-2,6-di-tert.-butylphenol (Ionol) in 5 ml Methanol abgestoppt und die Temperatur unter einem Stickstoffstrom auf Raumtemperatur ansteigen gelassen. Unter dem Mikroskop zeigt das Reaktionsgemisch dunkelviolette klettenartige Polyacetylengebilde mit einem Durchmesser von ca. 0,1 mm. Die Suspension enthält 2,5 g Polyacetylen pro Liter.

Die Entfernung des Katalysators erfolgt analog vorstehendem Beispiel.

## Beispiel 3

Herstellung einer Sprüh-Suspension mit dotiertem Polyacetylen.

Zu 1 l einer nach Beispiel 1 hergestellten Polyacetylen Suspension fügt man unter Rühren bei Raumtemperatur eine Lösung von 4 g Iod in 100 ml Toluol und rührt 2 Stunden bei Raumtemperatur nach. Die ursprünglich violette Lösung entfärbt sich, und man erhält eine dotierte klettenförmige Polyacetylenteilchen enthaltende Suspension.

Die Beispiele 4-11 beschreiben die Herstellung von Beschichtungen durch Besprühen eines Substrats mit einer Polyacetylen-Suspension.

Allgemeine Arbeitsweise für Beispiele 4 bis 6 : Ausgangspunkt für die Beschichtungsverfahren ist eine stabile Suspension von Polyacetylenteilchen in einem organischen Lösungsmittel. Polyacetylen ist im folgenden immer nur PAC abgekürzt.

## Beispiel 4

Eine 20 cm breite, 30 μm dicke Polycarbonatfolie wird in einer Kammer unter Schutzgasatmosphäre von einer Rolle abgewickelt, wobei eine Folienseite in einem Abstand von 30 cm mit einer Geschwindigkeit von 1 mm/sec am Polyacetylensprühkopf vorbeigeführt wird. Während des Sprühvorganges wurde der Sprühkopf auf- und abgesenkt, so daß eine homogene Massenbelegung ermöglicht wurde. Der Unterdruck in der Kammer wurde so eingestellt, daß das Lösungsmittel nach Niederschlag auf der Substratoberfläche spontan verdampfte und ein PAC-Film auf der Folienoberfläche wachsen konnte. Die Filmbildung war durch die Einstellung der Sprühstärke gut kontrollierbar. Der Zusammenhang zwischen Dicke der aufgesprühten Polyacetylenschicht und der Masse/Flächeneinheit war linear. Die Ausführungsbedingungen wurden so gewählt, daß die Polyacetylenschicht auf der Polycarbonat-Folie eine Dicke von 200 μm hatte und das Flächengewicht 5 mg/cm² betrug.

## Beispiel 5

Eine 1 m lange, 30 cm breite und 20 μm dicke Polyethylenfolie, auf deren Längsseiten 2 Kontaktstreifen aus Al aufgedampft waren, wurde mit dotiertem Polyacetylen beschichtet (300 μm) wie in Beispiel 4, wobei ein 2 cm breiter Randstreifen frei blieb. Anschließend wurde eine gut isolierende Teflonschicht über das ganze Flächengebilde gesprüht, so daß die Polyacetylenschicht von den beiden Kunststoffschichten ringsum eingeschlossen wurde. Die in dem Laminat liegende PAC-Schicht hatte eine quadratische Flächenleitfähigkeit von 10 Ohm. Bei einer aufgelegten Niederspannung von ca. 40 Volt konnte das Laminat auf ca. 30°-40 °C aufgewärmt und somit als Heizfolie verwendet werden.

## Beispiel 6

Eine 1 m lange, 30 cm breite und 30 μm dicke Polyesterfolie wurde mit einem transparenten Leiter aus Indium-Zinnoxid beschichtet und anschließend mit Polyacetylen beschichtet, wie in Beispiel 4.

Die Beispiele 7-9 beschreiben die Herstellung von Polyacetylenlaminaten durch Aufbringen einer Polyacetylensuspension unter Schutzgasatmosphäre durch Gießen, Walzen, Rakeln, Streichen oder einer Kombination dieser Methoden auf eine Trägerfolie.

## Beispiel 7

Eine 1 m breite und 30 μm dicke Polycarbonatfolie wird von einer Rolle abgewickelt und unter einem Vorratsbehälter mit PAC-Suspension und schlitzförmiger Öffnung und variabler Schlitzbreite entlanggeführt. Durch den Schlitz wurde ständig Polyacetylensuspension auf die Trägerfolie aufgebracht und durch ein nachgeschaltetes Rakelmesser glattgestrichen. Anschließend durchlief die beschichtete Polycarbonatfolie einen Wärmeofen mit Lösungsmittelabsaugung. Nach dem Trocknungsvorgang wurde die Folie zwischen zwei Preßwalzen geführt, wobei ein inniger Verbund zwischen der Polycarbonatfolie und der PAC-Schicht entstand.

## Beispiel 8

Wie Beispiel 7, anstelle der Polycarbonatfolie eine mit Nickel metallisierte Polycarbonatfolie.

## Beispiel 9

Wie in Beispiel 7, aber der Trocknungsvorgang ist nicht vollständig durchgeführt worden, so daß die PAC-Schicht noch feucht ist und Restlösungsmittel enthält. Beim Walzenvorgang wurden gleichzeitig ein Decklaminat aus Cellidor und Polyvinylidenchlorid aufgeprägt. Das Restlösungsmittel löste die Polyethylenschicht oberflächlich an, so daß ein fester Folienverbund entstand.

## Beispiel 10

Eine undotierte Polyacetylenfolie mit einer Dicke von 100 μm wird mit einer Polyethylenfolie mit einer Dicke von 20 μm belegt. Bei 100 °C werden beide Folien mit 200 bar 1 Minute zusammengepreßt. Man erhält ein Laminat mit einer Dicke von 70 μm.

## Beispiel 11

Analog vorstehendem Beispiel wurde ein Polyacetylenfolie beidseitig mit Polyethylen beschichtet. Die Dicke des Laminats beträgt 86 μm.

## Beispiel 12

Analog Beispiel 12 wurde eine Polyacetylenfolie beidseitig mit einer Verbundfolie aus Polyester und Polyvinylidenchlorid kaschiert, wobei die Polyesterseite mit dem Polyacetylen in Kontakt gebracht wurde.

## Beispiel 13

Eine Iod-dotierte Polyacetylenfolie wurde beidseitig mit einer Polyvinylidenchlorid-Folie von 20 μm Dicke belegt.
Unter Vakuum wurden die überstehenden Ränder der Polyvinylidenchlorid-Folie luftdicht verschweißt.

## Beispiel 14

Auf eine Folie aus Polyacetylen wird unter Verwendung eines Kontaktklebers auf Basis von Polychloropren eine Folie aus Polycarbonat aufgeklebt. Man erhält einen stabilen Verbund.

**Patentansprüche** (für die Vertragsstaaten : CH, IT, LI, NL)

1. Mehrschichtenflächengebilde aus mindestens 2 Schichten, das aus gegebenenfalls dotiertem Polyacetylen und mindestens einer weiteren, damit verbundenen Kunststoff-Folie besteht.
2. Flächengebilde gemäß Anspruch 1, dadurch gekennzeichnet, daß die Kunststoff-Folie für Sauerstoff undurchlässig ist.
3. Flächengebilde gemäß Anspruch 1, dadurch gekennzeichnet, daß die Polyacetylenschicht auf ihrer Unterseite und ihrer Oberseite mit einer Folie aus sauerstoffundurchlässigem Kunststoff verbunden ist und daß die Ränder des so gebildeten Laminats gegen Sauerstoffeinwirkung abgedichtet sind.
4. Verfahren zur Herstellung der Flächengebilde gemäß Anspruch 1, dadurch gekennzeichnet, daß man eine Folie aus Kunststoff und eine Folie aus Polyacetylen miteinander unter Druck- und/oder Wärmeeinwirkung kaschiert.
5. Verfahren gemäß Anspruch 4, dadurch gekennzeichnet, daß man eine Folie aus Polyacetylen ein- oder beidseitig mit einer Kunststoff-Folie kaschiert.
6. Verfahren gemäß Anspruch 4, dadurch gekennzeichnet, daß man auf eine Folie aus Kunststoff eine Suspension von kletten- oder faserförmigen Polyacetylenteilchen in einem organischen Suspendiermittel unter anaeroben Bedingungen aufsprüht und das Suspendiermittel entfernt.

**Patentansprüche** (für die Vertragsstaaten : DE, FR, GB)

1. Verfahren zur Herstellung von Mehrschichtenflächengebilden aus mindestens 2 Schichten, von denen mindestens eine aus gegebenenfalls dotiertem Polyacetylen und mindestens eine weitere, damit verbundene, aus einem folienbildenden Kunststoff besteht, dadurch gekennzeichnet, daß man eine Folie aus Kunststoff und eine Folie aus Polyacetylen miteinander unter Druck- und/oder Wärmeeinwirkung kaschiert.

2. Verfahren gemäß Anspruch 1, dadurch gekennzeichnet, daß man eine Folie aus Polyacetylen ein- oder beidseitig mit einer Kunststoff-Folie kaschiert.

3. Verfahren gemäß Anspruch 1, dadurch gekennzeichnet, daß man auf eine Folie aus Kunststoff eine Suspension von kletten- oder faserförmigen Polyacetylenteilchen in einem organischen Suspendiermittel unter aneroben Bedingungen aufsprüht und das Suspendiermittel entfernt.

**Claims** (for the Contracting States : CH, IT, LI, NL)

1. Multilayered sheet-like structure comprising at least 2 layers, which consists of optionally doped polyacetylene and, joined thereto, at least one further plastic film.

2. Sheet-like structure according to Claim 1, characterised in that the plastic film is impermeable to oxygen.

3. Sheet-like structure according to Claim 1, characterised in that the polyacetylene layer is joined, on its underside and its upper side, to a film of oxygen-impermeable plastic and in that the edges of the laminate thus formed are sealed against the effect of oxygen.

4. Process for the production of the sheet-like structures according to Claim 1, characterised in that a plastic film and a polyacetylene film are laminated to each other under the effect of pressure and/or heat.

5. Process according to Claim 4, characterised in that a polyacetylene film is laminated, on one or both sides, with a plastic film.

6. Process according to Claim 4, characterised in that a suspension of burr-shaped or fibrous polyacetylene particles in an organic suspending agent is sprayed on to a plastic film under anaerobic conditions and the suspending agent is removed.

**Claims** (for the Contracting States : DE, FR, GB)

1. Process for the production of multilayered sheet-like structures comprising at least 2 layers, of which at least one layer consists of optionally doped polyacetylene and at least one further layer, joined thereto, consists of a film-forming plastic, characterised in that a plastic film and a polyacetylene film are laminated to each other under the effect of pressure and/or heat.

2. Process according to Claim 1, characterised in that a polyacetylene film is laminated, on one or both sides, with a plastic film.

3. Process according to Claim 1, characterised in that a suspension of burr-shaped or fibrous polyacetylene particles in an organic suspending agent is sprayed on to a plastic film under anaerobic conditions and the suspending agent is removed.

**Revendications** (pour les Etats contractants : CH, IT, LI, NL)

1. Articles planiformes à plusieurs couches consistant en au moins deux couches, une couche de polyacétylène éventuellement dopé et au moins une autre feuille de matière plastique associée au polyacétylène.

2. Articles planiformes selon la revendication 1, caractérisés en ce que la feuille de matière plastique est imperméable à l'oxygène.

3. Articles planiformes selon la revendication 1, caractérisés en ce que la couche de polyacétylène est associée sur sa face inférieure et sur sa face supérieure à une feuille de matière plastique imperméable à l'oxygène, et en ce que les bords du stratifié ainsi formés sont rendus étanches à l'action de l'oxygène.

4. Procédé de préparation des articles planiformes selon la revendication 1, caractérisé en ce que l'on associe entre elles une feuille de matière plastique et une feuille de polyacétylène sous l'action de la pression et/ou de la chaleur.

5. Procédé selon la revendication 4, caractérisé en ce que l'on applique en doublage sur une feuille de polyacétylène, sur une face ou sur les deux, une feuille de matière plastique.

6. Procédé selon la revendication 4, caractérisé en ce que l'on pulvérise sur une feuille de matière plastique, à l'abri de l'air, une suspension de particules de polyacétylène ayant la forme de grappes ou de fibres dans un milieu de suspension organique, et on élimine le milieu de suspension.

**Revendications** (pour les Etats contractants : DE, FR, GB)

1. Procédé de préparation d'articles planiformes à plusieurs couches consistant en au moins deux couches dont l'une au moins consiste en polyacétylène éventuellement dopé et au moins une autre, associée à la première, consiste en une résine synthétique formant des feuilles, caractérisé en ce que l'on associe une feuille de matière plastique et une feuille de polyacétylène entre elles sous l'action de la pression et/ou de la chaleur.

2. Procédé selon la revendication 1, caractérisé en ce que l'on applique en doublage sur une feuille de polyacétylène, sur une face ou sur les deux, une feuille de matière plastique.

3. Procédé selon la revendication 1, caractérisé en ce que l'on pulvérise sur une feuille de matière plastique, à l'abri de l'air, une suspension de particules de polyacétylène ayant la forme de grappes ou de fibres dans un milieu de suspension organique, et on élimine le milieu de suspension.